# EUROPEAN PATENT APPLICATION

(11) **EP 4 814 508 A1**
(43) Date of publication of application: **30.09.2026**
(21) Application number: 25833301.2
(22) Date of filing: 26.06.2025
(51) Int. Cl.: G01R 31/374, G01R 31/367, G01R 31/385, G01R 31/382, G01R 31/396

(54) **ELECTRONIC DEVICE AND CURRENT CORRECTION METHOD THEREFOR**

(30) Priority: 03.07.2024 KR 20240087623
(71) Applicant: LG Energy Solution, Ltd., Seoul 07335 (KR)
(72) Inventor: CHAE, Minyoung, Daejeon 34122 (KR)
(74) Representative: Goddar, Heinz J.
(86) International application number: PCT/KR2025/009003
(87) International publication number: WO 2026/010242

(57) **Abstract**

A current correction method performed by an electronic device, according to one embodiment of the present disclosure, may comprise the operations of: acquiring state data related to the state of a battery disposed in a plurality of vehicles and charging data related to charging; extracting a reference current value of the battery under a designated condition on the basis of the state data and the charging data; and correcting, on the basis of the reference current value, a battery current value of the battery disposed in at least one vehicle from among the plurality of vehicles under the designated condition.

## Description

### Technical Field

The present disclosure claims the benefit based on Korean Patent Application No. 2024-0087623 filed on July 3, 2024, which is incorporated herein by reference in its entirety.

Example embodiments of the present disclosure relate to an electronic apparatus and current correction method thereof.

### Background Art

Recent years have seen active research and development in the field of secondary batteries. Here, the secondary battery refers to a rechargeable battery, including both conventional Ni/Cd batteries and Ni/MH batteries, as well as recent lithium-ion batteries. Among rechargeable batteries, the lithium-ion battery has an advantage of much higher energy density compared to the conventional Ni/Cd batteries and Ni/MH batteries. In addition, the lithium-ion battery may be produced to be compact and lightweight to be used for a power supply of portable devices, and as the usage has been widened to a power supply of an electric vehicle, the lithium-ion battery is in the limelight as a next generation energy storage medium.

A state and operation of a battery may be managed and controlled by a battery management system (BMS). The BMS and a battery may be included together within the same apparatus.

The BMS may obtain a state (for example, voltage, current, and temperature) value of a battery using a sensor. Meanwhile, in the case of a battery current sensor, the accuracy of a battery current measurement may decrease due to offset deviation caused by deviation occurring during mass production, temperature increase during vehicle operation, and performance degradation. Accordingly, to obtain an accurate battery current value, a current correction method is required to correct offset deviation of a current sensor.

### Detailed Description of the Invention

### Technical Goals

According to an example embodiment of the present disclosure, an electronic apparatus and a current correction method thereof may be provided to compensate offset deviation of a current sensor by correcting a current value of a battery obtained from a vehicle based on charging data and state data of the battery.

According to an example embodiment of the present disclosure, an electronic apparatus and a current correction method thereof may be provided to improve the accuracy of collected current data by extracting a mode of a current value in a predetermined condition of a battery as a reference value and correcting a current value of a battery.

Technical goals to be achieved by the example embodiments of the present disclosure are not limited thereto, and other technical goals may be inferred from example embodiments below.

### Technical solutions

A method of correcting current performed by using an electronic apparatus according to an example embodiment of the present disclosure may include obtaining state data associated with a state of a battery disposed in each of a plurality of vehicles and charging data associated with charging the battery, based on the state data and the charging data, extracting a reference current value for a predetermined battery condition. The method may further include, based on the reference current value, correcting a battery current value for the predetermined battery condition of a battery disposed in at least one of the plurality of vehicles.

In the method of correcting current performed by using an electronic apparatus according to an example embodiment of the present disclosure, the state data may include current data and temperature data of a battery obtained by a battery management system included in each of the plurality of vehicles.

In the method of correcting current performed by using an electronic apparatus according to an example embodiment of the present disclosure, the charging data may include charging current data obtained by a charge management system included in each of the plurality of vehicles.

In the method of correcting current performed by an electronic apparatus according to an example embodiment of the present disclosure, the predetermined battery condition may be a battery condition corresponding to a predetermined battery temperature value and a predetermined charging current value.

In the method of correcting current performed by an electronic apparatus according to an example embodiment of the present disclosure, the extracting of the reference current value may include, based on the current data, the temperature data, and the charging current data, extracting a plurality of battery current values corresponding to the predetermined battery temperature value and the predetermined charging current value, and, based on the plurality of battery current values, extracting the reference current value.

In the method of correcting current performed by an electronic apparatus according to an example embodiment of the present disclosure, the extracting of the reference current value may include extracting a mode among the plurality of battery current values as the reference current value.

The method of correcting current performed by using an electronic apparatus according to an example embodiment of the present disclosure may further include, based on the state data and the charging data, extracting a plurality of reference current values for a plurality of battery conditions, and, based on the plurality of reference current values, correcting a plurality of battery current values for the plurality of battery conditions of a battery disposed in the at least one vehicle. A number of the plurality of battery conditions may be N * M, N being a natural number referring to a number of a plurality of battery temperature values included in the state data, M being a natural number referring to a number of a plurality of charging current values included in the charging data.

An electronic apparatus, including a communication circuit and a processor functionally connected to the communication circuit. The processor, using the communication circuit, may be configured to obtain state data associated with a state of a battery disposed in each of a plurality of vehicles and charging data associated with charging the battery, based on the state data and the charging data, extract a reference current value for a predetermined battery condition, and based on the reference current value, correct a battery current value for the predetermined battery condition of a battery disposed in at least one vehicle among the plurality of vehicles.

In the electronic apparatus according to an example embodiment of the present disclosure, the state data may include current data and temperature data of a battery obtained by a battery management system included in each of the plurality of vehicles.

In the electronic apparatus according to an example embodiment of the present disclosure, the charging data may include charging current data obtained by a charge management system included in each of the plurality of vehicles.

In the electronic apparatus according to an example embodiment of the present disclosure, the predetermined battery condition may be a battery condition corresponding to a predetermined battery temperature value and a predetermined charging current value.

In the electronic apparatus according to an example embodiment of the present disclosure, the processor, based on the current data, the temperature data, and the charging current data, may be configured to extract a plurality of battery current values corresponding to the predetermined battery temperature value and the predetermined charging current value, and based on the plurality of battery current values, extract the reference current value.

In the electronic apparatus according to an example embodiment of the present disclosure, the processor may be further configured to extract a mode among the plurality of current values as the reference current value.

In the electronic apparatus according to an example embodiment of the present disclosure, the processor, based on the state data and the charging data, may be configured to extract a plurality of reference current values for a plurality of battery conditions, and based on the plurality of reference current values, correct a plurality of battery current values for the plurality of battery conditions of a battery disposed in the at least one vehicle. A number of the plurality of conditions may be N * M, N being a natural number referring to a number of a plurality of battery temperature values included in the state data, M being a natural number referring to a number of a plurality of charging current values included in the charging data.

A system according to an example embodiment of the present disclosure, including a battery charging apparatus, a plurality of vehicles that obtain state data associated with a state of a battery disposed in each of the plurality of vehicles and obtain charging data associated with charging of the battery from the battery charging apparatus, the battery charging apparatus being configured to perform charging of the battery by providing power to the battery. The system may further include on-board diagnostics (OBD) that may be configured to obtain the state data and the charging data from the plurality of vehicles, and an electronic apparatus that may be configured to obtain the state data and the charging data from the OBD. The electronic apparatus, based on the state data and the charging data, may extract a reference current value for a predetermined battery condition, and based on the reference current value, correct a battery current value for the predetermined battery condition of a battery disposed in at least one vehicle among the plurality of vehicles.

### Effects of the Invention

According to the example embodiments, it is possible to improve the accuracy of battery current measurement by compensating offset deviation of a battery current sensor.

Effects of the present disclosure are not limited to the aforementioned effects, and other effects not mentioned will be clearly understood by those skilled in the art from the description of the claims.

### Brief Description of Drawings

FIG. 1 is a block diagram of a current correction system including an electronic apparatus, on-board diagnostics (OBD), a vehicle, and a battery charging apparatus according to an example embodiment of the present disclosure.
FIG. 2 is a diagram illustrating an example of an electronic apparatus according to an example embodiment of the present disclosure extracting a plurality of battery current values in a predetermined condition based on charging data and state data.
FIG. 3 is a diagram illustrating an example of an electronic apparatus according to an example embodiment of the present disclosure extracting a reference current value in a predetermined condition based on a plurality of battery current values.
FIG. 4 is a diagram illustrating a plurality of reference current values in a plurality of conditions extracted by an electronic apparatus according to an example embodiment of the present disclosure as a form of a reference current map.
FIG. 5 is a flowchart of an operation of an electronic apparatus according to an example embodiment of the present disclosure.
FIG. 6 is a flowchart of an operation of an electronic apparatus according to an example embodiment of the present disclosure.

### Mode for Carrying Out the Invention

In describing the example embodiments, descriptions of technical contents that are well known in the art to which the present disclosure belongs and are not directly related to the present specification will be omitted. This is to more clearly communicate without obscuring the subject matter of the present specification by omitting unnecessary description.

For the same reason, in the accompanying drawings, some components are exaggerated, omitted or schematically illustrated. In addition, the size of each component does not fully reflect the actual size. The same or corresponding components in each drawing are given the same reference numerals.

Advantages and features of the present disclosure and methods of achieving them will be apparent from the following example embodiments that will be described in more detail with reference to the accompanying drawings. It should be noted, however, that the present disclosure is not limited to the following example embodiments, and may be implemented in various forms. Accordingly, the example embodiments are provided only to disclose the present disclosure and let those skilled in the art know the category of the present disclosure. In the drawings, embodiments of the present disclosure are not limited to the specific examples provided herein and are exaggerated for clarity. The same reference numerals or the same reference designators denote the same elements throughout the specification.

At this point, it will be understood that each block of the flowchart illustrations and combinations of flowchart illustrations may be performed by computer program instructions. Since these computer program instructions may be mounted on a processor of a general purpose computer, special purpose computer, or other programmable data processing equipment, those instructions executed through the computer or the processor of other programmable data processing equipment may create a means to perform the functions described in flowchart block(s). These computer program instructions may be stored in a computer usable or computer readable memory that can direct a computer or other programmable data processing equipment to implement functionality in a particular manner, and thus the computer usable or computer readable memory. It is also possible for the instructions stored in to produce an article of manufacture containing instruction means for performing the functions described in the flowchart block(s). Computer program instructions may also be mounted on a computer or other programmable data processing equipment, such that a series of operating steps may be performed on the computer or other programmable data processing equipment to create a computer-implemented process to create a computer or other programmable data. Instructions for performing the processing equipment may also provide steps for performing the functions described in the flowchart block(s).

In addition, each block may represent a portion of a module, segment, or code that includes one or more executable instructions for executing a specified logical function(s). It should also be noted that in some alternative implementations, the functions noted in the blocks may occur out of order. For example, the two blocks shown in succession may in fact be executed substantially concurrently, or the blocks may sometimes be executed in the reverse order, depending on the corresponding function.

At this point, the term "unit" may refer to a software or a hardware element such as a field-programmable gate array (FPGA) or an application-specific integrated circuit (ASIC), and a "unit" may perform predetermined roles. However, the "unit" is not limited to software or hardware. A "unit" may be configured to be in an addressable storage medium or to regenerate one or more processors. Accordingly, as an example, a "unit" may include software elements, object-oriented software elements, elements such as class elements and task elements, processes, functions, properties, procedures, subroutines, segments of program code, drivers, firmware, microcode, a circuit, data, a database, data structures, tables, arrays, and variables. A function provided within elements and "units" may be combined into a smaller number of elements and "units", or separated further into additional elements and "units". In addition, components and "units" may be implemented to regenerate one or more CPUs within a device or a secure multimedia card.

The expression "at least one of A, B, and C" may indicate the following meaning including: A alone; B alone; C alone; both A and B together; both A and C together; both B and C together; or all three of A, B, and C together.

In the present disclosure, a "terminal" may be implemented as a computer or a portable terminal capable of accessing a server or another terminal through a network. Here, the computer may include, for example, a laptop computer, a desktop computer, and a notebook equipped with a web browser. The portable terminal may be a wireless communication device ensuring a portability and a mobility, and include any type of handheld wireless communication device, for example, a tablet PC, a smartphone, a communication-based terminal such as international mobile telecommunication (IMT), code division multiple access (CDMA), W-code division multiple access (W-CDMA), and long term evolution (LTE).

In the following description, example embodiments of the present disclosure will be described in detail with reference to the drawings so that those skilled in the art can easily carry out the present disclosure. The present disclosure may be embodied in many different forms and is not limited to the example embodiments described herein.

Hereinafter, example embodiments of the present disclosure will be described with reference to the drawings.

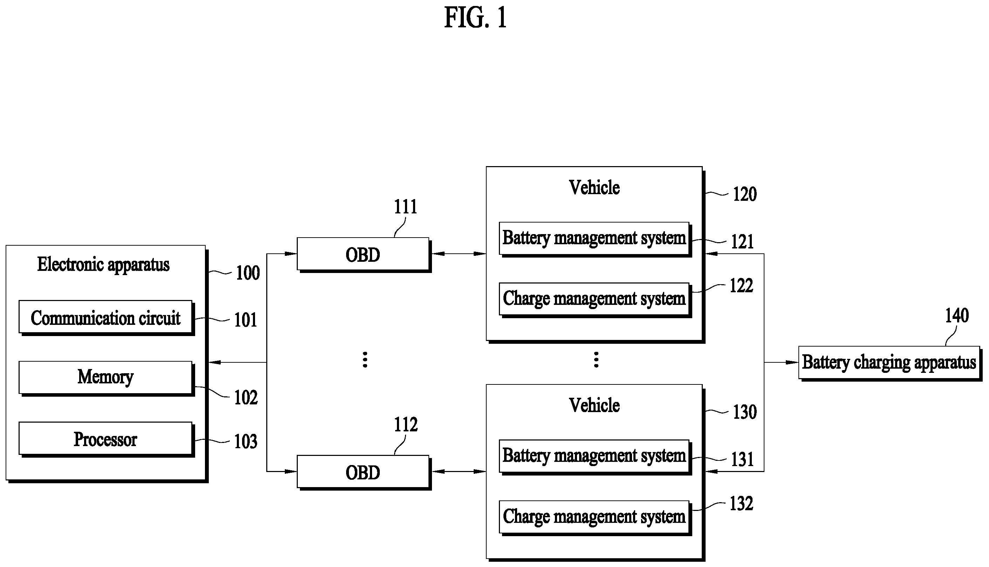

FIG. 1 is a block diagram of a current correction system including an electronic apparatus 100, on-board diagnostics (OBD) 111 and 112, vehicles 120 and 130, and a battery charging apparatus 140 according to an example embodiment of the present disclosure. Although FIG. 1 illustrates that two OBD 111 and 112 and two vehicles 120 and 130 are included in the current correction system, but is not limited thereto, and the current correction system may include three or more OBD and vehicles.

Referring to FIG. 1, the electronic apparatus 100 may include a communication circuit 101, a memory 102, and a processor 103. According to an example embodiment, the electronic apparatus 100 may further include at least one element (for example, a display, an input device, or an output device) in addition to the elements illustrated in FIG. 1. The electronic apparatus 100 may include at least one of a notebook, a desktop computer, a laptop computer, and a server computing device. However, the electronic apparatus 100 is not limited thereto, and may include all types of devices provided with a computing function and a communication function.

According to an example embodiment, the communication circuit 101 may establish a wired communication channel and/or a wireless communication channel between the electronic apparatus 100 and the OBD 111 and 112, and transmit and receive data to and from the OBD 111 and 112 through an established communication channel. For example, the communication circuit 101 may receive state data associated with a state of a battery disposed in a plurality of vehicles 120 and 130 and charging data associated with charging through the wired communication channel and/or the wireless communication channel.

Here, communication, in other words, data transmission and reception may be carried out via a wired channel or a wireless channel. To this end, the communication circuit 101 may include a wired communication module that connects to the Internet through a local area network (LAN), a mobile communication module that connects to a mobile communication network through a mobile communication base station to transmit and receive data, a short-range communication module that uses communication methods of wireless local area network (WLAN) such as Wi-Fi, or wireless personal area network (WPAN) such as Bluetooth and Zigbee, and a satellite communication module that uses global navigation satellite system (GNSS) such as global positioning system (GPS), and a combination thereof.

According to an example embodiment, the memory 102 may include a volatile memory and/or a non-volatile memory.

According to an example embodiment, the memory 102 may store data used by at least one element (for example, the processor 103) of the electronic apparatus 100. For example, the data may include software (or, an instruction associated with the software), input data, or output data. According to an example embodiment, when executed by the processor 103, an instruction may allow the electronic apparatus 100 to perform operations defined by the instruction.

According to an example embodiment, the processor 103 may be embodied as a computer or a similar device depending on hardware, software, or a combination thereof. Hardware-wise, the processor 103 may be embodied as a form of an electronic circuit performing a control function by processing an electrical signal, and software-wise, embodied as a form of a program operating a hardware processor 103. According to an example embodiment, the processor 103 may include a central processing unit (CPU), an application processor, a graphics processing unit (GPU), a neural processing unit (NPU), an image signal processor (ISP), a sensor hub processor, and a communication processor.

Meanwhile, if description below does not specifically mention, it may be construed that an operation of the electronic apparatus 100 is performed by a control of the processor 103.

According to an example embodiment, the OBD 111 and 112 may be electrically connected to the vehicles 120 and 130 and may obtain various types of data from elements included in the vehicles 120 and 130. Here, each of the OBD 111 and 112 may correspond one-to-one to the vehicles 120 and 130, and may be electrically connected to the vehicles 120 and 130, respectively. For example, the OBD 111 may be electrically connected to a vehicle 120 and may obtain various types of data from the vehicle 120. According to an example embodiment, the OBD 111 and 112 may diagnose a state of the vehicles 120 and 130 based on obtained data.

According to an example embodiment, the OBD 111 and 112 may transmit and receive data with elements included in the vehicles 120 and 130 (for example, battery management systems 121 and 131), a charge management system 122 and 132, and the electronic apparatus 100 using a communication circuit. For example, the OBD 111 and 112 may obtain state data associated with a state (for example, voltage, current, temperature, state of charge (SOC), state of health (SOH), and/or whether an abnormality exists) of a battery disposed in the vehicles 120 and 130 from the battery management systems 121 and 131 through controller area network (CAN) communication. In addition, the OBD 111 and 112 may obtain charging data associated with charging of the battery disposed in the vehicles 120 and 130 from charge management systems 122 and 132 through CAN communication. The OBD 111 and 112 may transmit the obtained state data and charging data of the battery to the electronic apparatus 100 based on wireless communication.

According to an example embodiment, each of the plurality of vehicles 120 and 130 may include the battery management systems (BMS) 121 and 122, the OBD 111 and 112, and the charge management systems (CMS) 122 and 132.

According to an example embodiment, the BMS 121 and 131 may manage and control the battery disposed in the vehicles 120 and 130. For example, the BMS 121 and 131 may monitor voltage, current, and/or temperature of the battery by using a sensor, and based on a monitoring result, diagnose SOC, SOH, and/or whether an abnormality exists of the battery. In addition, the BMS 121 and 131 may control charge and discharge of the battery.

According to an example embodiment, the CMS 122 and 132 may manage and control charge of the battery disposed in the vehicles 120 and 130 by the battery charging apparatus 140. For example, the CMS 122 and 132 may manage and control power supplied to the battery disposed in the vehicles 120 and 130 from the battery charging apparatus 140. According to an example embodiment, the CMS 122 and 132 may obtain charging data from the battery charging apparatus 140. For example, the charging data may include at least one of charging voltage data, charging current data, and charging power data.

According to an example embodiment, the battery charging apparatus 140 may be electrically connected to the vehicles 120 and 130 and may perform charging by supplying power to the battery disposed in the vehicles 120 and 130. The battery charging apparatus 140 may set at least one of charging voltage, charging current, and charging power when charging the battery disposed in the vehicles 120 and 130. The battery charging apparatus 140 may transmit the charging data including at least one of a set charging voltage, charging current, and charging power to the vehicles 120 and 130. More specifically, the battery charging apparatus 140 may transmit the charging data to the CMS 122 and 132 included in the vehicles 120 and 130.

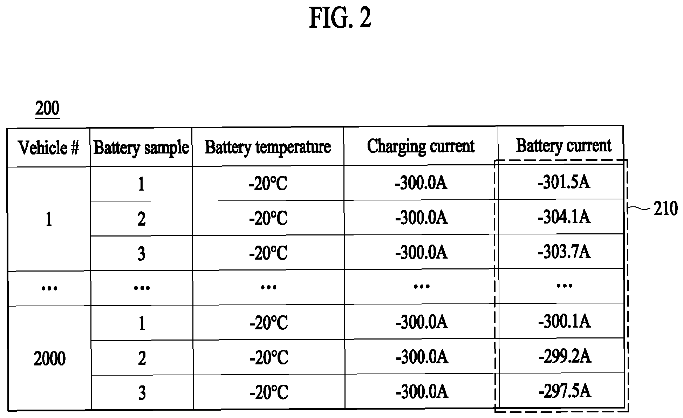

Hereinafter, a method of performing current correction by the electronic apparatus 100 will be described with reference to FIGS. 2 to 4.

According to an example embodiment, the electronic apparatus 100 may obtain state data associated with a state of the battery disposed in the plurality of vehicles 120 and 130 and charging data associated with charging. According to an example embodiment, the electronic apparatus 100 may obtain the state data and the charging data from the OBD 111 and 112. For example, the state data may include current data and temperature data of a battery obtained by the BMS 121 and 131. In addition, the charging data may include charging current data obtained by the CMS 122 and 132. Here, the current data, the temperature data, and the charging current data may be time-series data indicating current, temperature, and charging current of a battery throughout time, respectively.

According to an example embodiment, the electronic apparatus 100 may extract a reference current value in a predetermined condition of a battery based on the state data and the charging data. Here, the predetermined condition may be a condition corresponding to a predetermined battery temperature value and a predetermined charging current value. In addition, the reference current value may correspond one-to-one to a predetermined condition. For example, the electronic apparatus 100 may extract the reference current value in a condition in which a temperature value of a battery is a predetermined battery temperature value and a charging current value is a predetermined charging current value.

According to an example embodiment, the electronic apparatus 100 may extract a plurality of battery current values corresponding to the predetermined battery temperature value and the predetermined charging current value based on obtained current data, temperature data, and charging current data. For example, the electronic apparatus 100 may extract the plurality of battery current values at a point at which the battery temperature value is the predetermined battery temperature value and the charging current value is the predetermined charging current value, based on current data, temperature data, and charging current data, which are time-series data. Here, each of the plurality of battery current values may correspond one-to-one to a plurality of batteries disposed in the plurality of vehicles 120 and 130.

FIG. 2 is a diagram illustrating an example of an electronic apparatus extracting a plurality of battery current values in a predetermined condition based on charging data and state data according to an example embodiment of the present disclosure.

Referring to FIG. 2, the electronic apparatus 100 may identify data 200 that is extracted based on current data, temperature data, and charging current data. The data 200 may include a plurality of battery current values 210 of a plurality of battery samples in a predetermined condition (for example, a condition in which a battery temperature value is -20°C, and a charging current value is -300A). Here, each of the plurality of battery samples may be batteries included in the plurality of vehicles 120 and 130. At this point, the battery samples included in the same vehicle may have different battery current values depending on a connection structure within the vehicle even in the same condition. For example, in the data 200, a vehicle 1 may include a battery sample 1 having a battery current value of -301.5A, a battery sample 2 having a battery current value of -304.1A, and a battery sample 3 having a battery current value of -303.7A in a predetermined condition. According to an example embodiment, the electronic apparatus 100 may extract the battery current values 210 in a predetermined condition of a battery included in the plurality of vehicles 120 and 130 based on the data 200.

According to an example embodiment, the electronic apparatus 100 may extract a reference current value in a predetermined condition of a battery based on the plurality of battery current values 210. For example, the electronic apparatus 100 may extract a mode among the plurality of battery current values 210 as a reference current value.

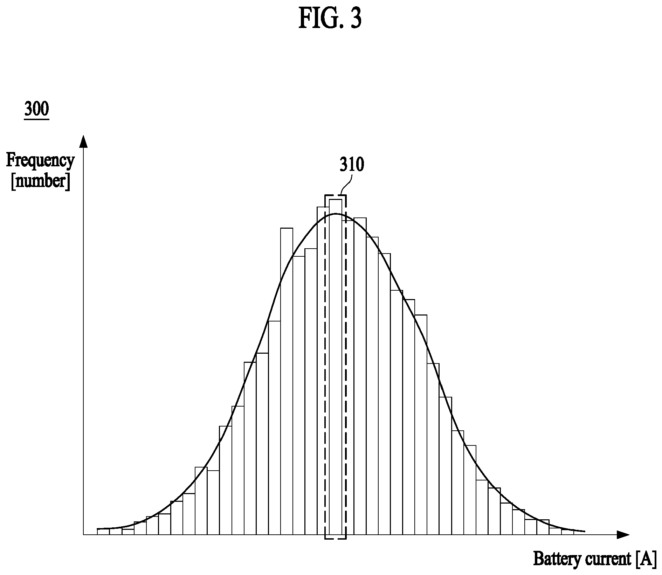

FIG. 3 is a diagram illustrating an example of the electronic apparatus 100 according to an example embodiment of the present disclosure extracting a reference current value in a predetermined condition based on a plurality of battery current values.

Referring to FIG. 3, a graph 300 illustrates an extracted plurality of battery current values based on a frequency per battery current value. According to an example embodiment, the electronic apparatus 100 may extract a battery current value corresponding to data 310 indicating a mode in the graph 300 as the reference current value.

According to an example embodiment, the electronic apparatus 100 may correct a battery current value in a predetermined condition of a battery disposed in at least one vehicle among the plurality of vehicles 120 and 130 based on the reference current value. For example, the electronic apparatus 100 may correct the battery current value in the predetermined condition of the battery identically to the reference current value.

According to an example embodiment, the electronic apparatus 100 may extract a plurality of reference current values in a plurality of conditions of a battery based on state data and charging data. Here, the plurality of reference current values may correspond one-to-one to the plurality of conditions. In addition, the number of the plurality of conditions may be N * M, in which N (note that N is a natural number) refers to the number of a plurality of battery temperature values included in the state data, and M (note that M is a natural number) refers to the number of a plurality of charging current values included in the charging data.

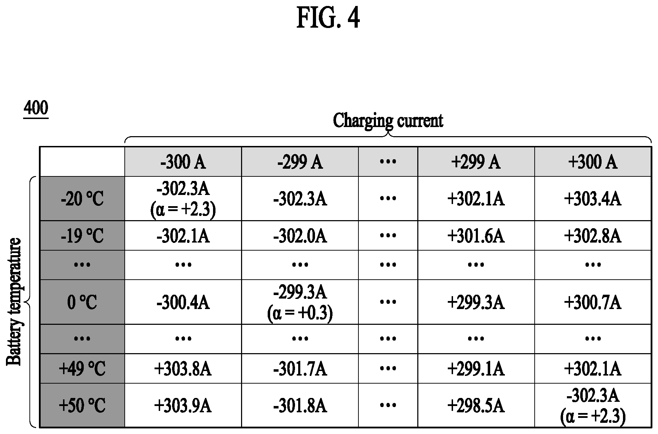

FIG. 4 is a diagram illustrating a plurality of reference current values extracted by the electronic apparatus 100 according to an example embodiment of the present disclosure in a plurality of conditions as a form of a reference current map.

Referring to FIG. 4, a reference current map 400 may exhibit a reference current value per each condition. For example, in a first condition in which a battery temperature value is -20°C, and a charging current value is -300A, a first reference current value may be - 302.3A, and in a second condition in which a battery temperature value is 0°C, and a charging current value is -299A, a second reference current value may be -299.3A, and in a third condition in which a battery temperature value is 50°C, and a charging current value is 300A, a third reference current value may be -302.3A. In the reference current map 400, the number of the plurality of conditions may be 42,671, resulting from multiplying 71, the number of battery temperature values, and 601, the number of a plurality of charging current values.

According to an example embodiment, the electronic apparatus 100 may correct a plurality of battery current values in a plurality of conditions of a battery disposed in at least one vehicle among the plurality of vehicles 120 and 130 based on a plurality of reference current values. For example, when a battery current value is -304.6A in the first condition in which a battery temperature value of the vehicle 110 is -20°C, and a charging current value is -300A, the electronic apparatus 100 may correct the battery current value in the first condition of a battery of the vehicle 110 to -302.3A, which is the same as the first reference current value, by applying a correction value (α) of +2.3A.

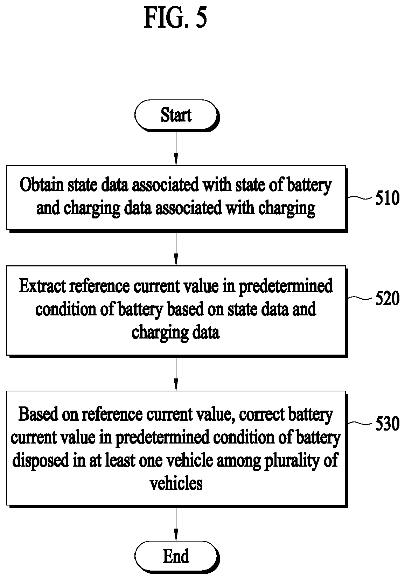

FIG. 5 is a flowchart of an operation of an electronic apparatus according to an example embodiment of the present disclosure. As an operation method of FIG. 5 may be performed by the electronic apparatus 100 of FIG. 1, description overlapping with the aforementioned content may be omitted, and the operation method of FIG. 5 may be described using configurations of FIG. 1.

An example embodiment illustrated in FIG. 5 is merely an example, and an operation sequence according to various example embodiments of the present disclosure may be different from what is described in FIG. 5, and some operations illustrated in FIG. 5 may be omitted, and the operation sequence may be changed, or operations may be combined.

Referring to FIG. 5, in operation 510, the electronic apparatus 100 may obtain state data associated with a state of a battery disposed in the plurality of vehicles 120 and 130 and charging data associated with charging. According to an example embodiment, the electronic apparatus 100 may obtain the state data and the charging data from the OBD 111 and 112.

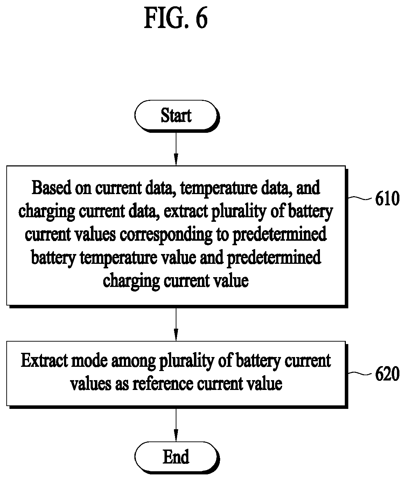

In operation 520, the electronic apparatus 100 may extract a reference current value in a predetermined condition of a battery based on the state data and the charging data. An operation of the electronic apparatus 100 extracting the reference current value in the predetermined condition of the battery will be described in detail through FIG. 6 described later.

In operation 530, the electronic apparatus 100 may correct a battery current value in the predetermined condition of the battery disposed in at least one vehicle among the plurality of vehicles 120 and 130 based on the reference current value extracted in operation 520.

FIG. 6 is a flowchart of an operation of an electronic apparatus according to an example embodiment of the present disclosure. As an operation method of FIG. 6 may be performed by the electronic apparatus 100 of FIG. 1, description overlapping with the aforementioned content may be omitted, and the operation method of FIG. 6 may be described using configurations of FIG. 1.

An example embodiment illustrated in FIG. 6 is merely an example, and an operation sequence according to various example embodiments of the present disclosure may be different from what is described in FIG. 6, and some operations illustrated in FIG. 6 may be omitted, and the operation sequence may be changed, or operations may be combined.

Referring to FIG. 6, in operation 610, the electronic apparatus 100 may extract a plurality of battery current values corresponding to a predetermined battery temperature value and a predetermined charging current value based on current data, temperature data, and charging current data.

In operation 620, the electronic apparatus 100 may extract a mode among the plurality of battery current values extracted in operation 610 as a predetermined current value.

The battery management apparatus in accordance with the above-described example embodiments may include a processor, a memory which stores and executes program data, a permanent storage such as a disk drive, a communication port for communication with an external device, and a user interface device such as a touch panel, a key, and an icon. Methods realized by software modules or algorithms may be stored in a computer-readable recording medium as computer-readable codes or program commands which may be executed by the processor. Here, the computer-readable recording medium may be a magnetic storage medium (for example, a read-only memory (ROM), a random-access memory (RAM), a floppy disk, or a hard disk) or an optical reading medium (for example, a CD-ROM or a digital versatile disc (DVD)). The computer-readable recording medium may be dispersed to computer systems connected by a network so that computer-readable codes may be stored and executed in a dispersion manner. The medium may be read by a computer, may be stored in a memory, and may be executed by the processor.

The present example embodiments may be represented by functional blocks and various processing steps. These functional blocks may be implemented by various numbers of hardware and/or software configurations that execute specific functions. For example, the present example embodiments may adopt direct circuit configurations such as a memory, a processor, a logic circuit, and a look-up table that may execute various functions by control of one or more microprocessors or other control devices. Similarly to that elements may be executed by software programming or software elements, the present example embodiments may be implemented by programming or scripting languages such as C, C++, Java, and assembler including various algorithms implemented by combinations of data structures, processes, routines, or of other programming configurations. Functional aspects may be implemented by algorithms executed by one or more processors. In addition, the present example embodiments may adopt the related art for electronic environment setting, signal processing, and/or data processing, for example. The terms "mechanism", "element", "means", and "configuration" may be widely used and are not limited to mechanical and physical components. These terms may include meaning of a series of routines of software in association with a processor, for example.

The above-described example embodiments are merely examples, and other embodiments may be implemented within the scope of the following claims.

## Claims

1. A method of correcting current performed by using an electronic apparatus, the method comprising:
obtaining state data associated with a state of a battery disposed in each of a plurality of vehicles and charging data associated with charging of the battery;
based on the state data and the charging data, extracting a reference current value for a predetermined battery condition; and
based on the reference current value, correcting a battery current value for the predetermined battery condition of a battery disposed in at least one vehicle of the plurality of vehicles.

2. The method of claim 1,
wherein the state data includes current data and temperature data of a battery obtained by a battery management system included in each of the plurality of vehicles.

3. The method of claim 2,
wherein the charging data includes charging current data obtained by a charge management system included in each of the plurality of vehicles.

4. The method of claim 3,
wherein the predetermined battery condition is a battery condition corresponding to a predetermined battery temperature value and a predetermined charging current value.

5. The method of claim 4,
wherein the extracting of the reference current value comprises:
based on the current data, the temperature data, and the charging current data, extracting a plurality of battery current values corresponding to the predetermined battery temperature value and the predetermined charging current value; and
based on the plurality of battery current values, extracting the reference current value.

6. The method of claim 5,
wherein the extracting of the reference current value includes extracting a mode among the plurality of battery current values as the reference current value.

7. The method of claim 1, further comprising:
based on the state data and the charging data, extracting a plurality of reference current values for a plurality of battery conditions; and
based on the plurality of reference current values, correcting a plurality of battery current values for the plurality of battery conditions of the battery disposed in the at least one vehicle, and
wherein a number of the plurality of battery conditions is N * M, N being a natural number referring to a number of a plurality of battery temperature values included in the state data, M being a natural number referring to a number of a plurality of charging current values included in the charging data.

8. An electronic apparatus, comprising:
a communication circuit; and
a processor functionally connected to the communication circuit,
wherein the processor is configured to:
using the communication circuit, obtain state data associated with a state of a battery disposed in each of a plurality of vehicles and charging data associated with charging of the battery,
based on the state data and the charging data, extract a reference current value for a predetermined battery condition, and
based on the reference current value, correct a battery current value for the predetermined battery condition of a battery disposed in at least one vehicle among the plurality of vehicles.

9. The electronic apparatus of claim 8,
wherein the state data includes current data and temperature data of a battery obtained by a battery management system included in each of the plurality of vehicles.

10. The electronic apparatus of claim 9,
wherein the charging data includes charging current data obtained by a charge management system included in each of the plurality of vehicles.

11. The electronic apparatus of claim 10,
wherein the predetermined battery condition is a battery condition corresponding to a predetermined battery temperature value and a predetermined charging current value.

12. The electronic apparatus of claim 11,
wherein the processor is configured to:
based on the current data, the temperature data, and the charging current data, extract a plurality of battery current values corresponding to the predetermined battery temperature value and the predetermined charging current value, and
based on the plurality of battery current values, extract the reference current value.

13. The electronic apparatus of claim 12,
wherein the processor is configured to extract a mode among the plurality of battery current values as the reference current value.

14. The electronic apparatus of claim 8,
wherein the processor is further configured to:
based on the state data and the charging data, extract a plurality of reference current values for a plurality of battery conditions, and
based on the plurality of reference current values, correct a plurality of battery current values for the plurality of battery conditions of the battery disposed in the at least one vehicle, and
wherein a number of the plurality of battery conditions is N * M, N being a natural number and referring to a number of a plurality of battery temperature values included in the state data, M being a natural number and referring to a number of a plurality of charging current values included in the charging data.

15. A system, comprising:
a battery charging apparatus;
a plurality of vehicles that obtain state data associated with a state of a battery and obtain charging data associated with charging of the battery from the battery charging apparatus, the battery charging apparatus being configured to perform charging of the battery by providing power to the battery;
on-board diagnostics (OBD) configured to obtain the state data and the charging data from the plurality of vehicles; and
an electronic apparatus configured to obtain the state data and the charging data from the OBD,
wherein the electronic apparatus is configured to:
based on the state data and the charging data, extract a reference current value for a predetermined battery condition, and
based on the reference current value, correct a battery current value for the predetermined battery condition of a battery disposed in at least one vehicle among the plurality of vehicles.
